# EUROPÄISCHE PATENTANMELDUNG

(11) **EP 4 357 960 A1**
(43) Veröffentlichungstag der Anmeldung: **24.04.2024**
(21) Anmeldenummer: 22203111.4
(22) Anmeldetag: 21.10.2022
(51) Int. Cl.: G06F 30/13

(54) **COMPUTERIMPLEMENTIERTES VERFAHREN ZUR CODIERUNG, ÜBERTRAGUNG UND DECODIERUNG VON GERÜSTDATEN**

(71) Anmelder: PERI SE, 89264 Weißenhorn (DE)
(72) Erfinder: Nowotny, Konstantin, 89264 Weissenhorn (DE); Rainer, Dieter, 89264 Weissenhorn (DE); Dietz, Oliver, 33178 Borchen (DE); Loddenkemper, Jan, 59597 Erwitte (DE); Schmidt, Tobias, 89264 Weissenhorn (DE)
(74) Vertreter: Müller Schupfner & Partner Patent- und Rechtsanwaltspartnerschaft mbB

(57) **Zusammenfassung**

Computerimplementiertes Verfahren zur Codierung, Übertragung und Decodierung von Gerüstdaten, umfassend: Bereitstellen zumindest einer Gerüstdatenbank, in der zumindest Gerüstfeldcodierungen für vordefinierte Gerüstfelder, Bauteilcodierungen für vordefinierte Gerüstbauteile, sowie Informationen über die Geometrie der Gerüstfelder und Gerüstbauteile enthalten sind; Bereitstellen von Gerüstdaten eines Gerüstes, umfassend Informationen zu den im Gerüst vorgesehenen Gerüstfelder und den in den jeweiligen Gerüstfeldern vorgesehenen Gerüstbauteile; Zuordnen von Gerüstfeldcodierungen aus der Gerüstdatenbank zu den Gerüstfeldern des Gerüstes; Zuordnen von Bauteilcodierungen aus der Gerüstdatenbank zu den in den jeweiligen Gerüstfeldern vorgesehenen Gerüstbauteile, wobei die Bauteilcodierungen eines jeweiligen Gerüstfeldes mit der Gerüstfeldcodierung des jeweiligen Gerüstfeldes verknüpft ist; Übermitteln der jeweiligen Gerüstfeldcodierungen und der damit verknüpften Bauteilcodierungen an eine mobile Rechnereinheit, wobei die mobile Rechnereinheit Zugriff auf die zumindest eine Gerüstdatenbank hat; Bereitstellen einer digitalen Gerüstansicht durch Decodieren der übermittelten Gerüstfeld- und Bauteilcodierungen und durch Zugriff auf die zumindest eine Gerüstdatenbank.

## Beschreibung

### Gebiet der Erfindung

Die vorliegende Erfindung betrifft ein computerimplementiertes Verfahren zur Codierung, Übertragung und Decodierung von Gerüstdaten, ein System zur Codierung, Übertragung und Decodierung von Gerüstdaten, ein korrespondierendes Computerprogrammelement und eine Verwendung einer Gerüstdatenbank in einem solchen Verfahren/System.

### Hintergrund der Erfindung

Im Stand der Technik sind verschiedene Systeme zur digitalen Projektplanung, Visualisierung und Unterstützung der Auf- und Abbauvorgänge von Gerüsten bekannt. Solche Systeme vergleichbar mit CAD-Systemen, mit denen unter anderem verschiedene zwei- und/oder dreidimensionale Gerüstansichten bereitgestellt werden können. Für ein jeweiliges Gerüst kann dabei eine entsprechende Gerüstdatei erstellt werden, in der die jeweiligen Gerüstspezifikationen enthalten sind. In der Praxis hat sich dabei herausgestellt, dass derartige Gerüstdateien häufig derart groß sind, dass eine drahtlose Übermittlung an eine mobile Rechnereinheit nicht möglich ist bzw. nur unter hohem Zeitaufwand möglich ist.

Es hat sich daher herausgestellt, dass ein Bedarf besteht, ein Verfahren und/oder ein System bereitzustellen, mit dem eine möglichst einfacher und schneller Übermittlung von Gerüstdaten an eine mobile Rechnereinheit ermöglicht werden kann.

Vor diesem Hintergrund ist es eine Aufgabe der vorliegenden Erfindung, ein Verfahren und/oder ein System bereitzustellen, mit dem eine möglichst einfacher und schneller Übermittlung von Gerüstdaten an eine mobile Rechnereinheit ermöglicht werden kann. Diese und andere Aufgaben, die beim Lesen der folgenden Beschreibung noch genannt werden oder vom Fachmann erkannt werden können, werden durch den Gegenstand der unabhängigen Ansprüche gelöst. Die abhängigen Ansprüche bilden den zentralen Gedanken der vorliegenden Erfindung in besonders vorteilhafter Weise weiter.

### Zusammenfassung der Erfindung

Ein Aspekt der vorliegenden Erfindung bezieht sich auf ein computerimplementiertes Verfahren zur Codierung, Übertragung und Decodierung von Gerüstdaten, umfassend:
Bereitstellen zumindest einer Gerüstdatenbank, in der zumindest Gerüstfeldcodierungen für vordefinierte Gerüstfelder, Bauteilcodierungen für vordefinierte Gerüstbauteile, sowie Informationen über die Geometrie der Gerüstfelder und Gerüstbauteile enthalten sind;
Bereitstellen von Gerüstdaten eines Gerüstes, umfassend Informationen zu den im Gerüst vorgesehenen Gerüstfelder und den in den jeweiligen Gerüstfeldern vorgesehenen Gerüstbauteile;
Zuordnen von Gerüstfeldcodierungen aus der Gerüstdatenbank zu den Gerüstfeldern des Gerüstes;
Zuordnen von Bauteilcodierungen aus der Gerüstdatenbank zu den in den jeweiligen Gerüstfeldern vorgesehenen Gerüstbauteile, wobei die Bauteilcodierungen eines jeweiligen Gerüstfeldes mit der Gerüstfeldcodierung des jeweiligen Gerüstfeldes verknüpft ist;
Übermitteln der jeweiligen Gerüstfeldcodierungen und der damit verknüpften Bauteilcodierungen an eine mobile Rechnereinheit, wobei die mobile Rechnereinheit Zugriff auf die zumindest eine Gerüstdatenbank hat;
Bereitstellen einer digitalen Gerüstansicht durch Decodieren der übermittelten Gerüstfeld- und Bauteilcodierungen und durch Zugriff auf die zumindest eine Gerüstdatenbank.

Ein weiterer Aspekt der vorliegenden Erfindung betrifft ein System zur Codierung, Übertragung und Decodierung von Gerüstdaten, umfassend:
eine Bereitstelleinheit eingerichtet zum Bereitstellen zumindest einer Gerüstdatenbank, in der zumindest Codierungen für vordefinierte Gerüstfelder, Codierungen für vordefinierte Gerüstbauteile, sowie Informationen über die Geometrie der Gerüstfelder und Gerüstbauteile enthalten sind;
eine weitere Bereitstelleinheit eingerichtet zum Bereitstellen von Gerüstdaten eines Gerüstes, umfassend Informationen zu den im Gerüst vorgesehenen Gerüstfelder und den in den jeweiligen Gerüstfeldern vorgesehenen Gerüstbauteile;
eine Zuordnungseinheit eingerichtet zum Zuordnen von Codierungen aus der Gerüstdatenbank zu den Gerüstfeldern des Gerüstes;
eine weitere Zuordnungseinheit eingerichtet zum Zuordnen von Codierungen aus der Gerüstdatenbank zu den in den jeweiligen Gerüstfeldern vorgesehenen Gerüstbauteile, wobei die Codierungen der Gerüstbauteile eines jeweiligen Gerüstfeldes mit der Codierung des jeweiligen Gerüstfeldes verknüpft ist;
eine Übermittlungseinheit eingerichtet zum Übermitteln der Codierungen der jeweiligen Gerüstfelder und der damit verknüpften Codierungen der darin jeweils vorgesehenen Gerüstbauteile an eine mobile Rechnereinheit, wobei die mobile Rechnereinheit Zugriff auf die zumindest eine Gerüstdatenbank hat;
eine weitere Bereitstelleinheit eingerichtet zum Bereitstellen einer digitalen Gerüstansicht durch Decodieren der übermittelten Codierungen und Zugriff auf die zumindest eine Gerüstdatenbank.

Ein weiterer Aspekt der vorliegenden Erfindung betrifft ein Computerprogrammelement mit Anweisungen, die bei Ausführung auf Computergeräten einer Computerumgebung eingerichtet sind, die Schritte der genannten computerimplementierten Verfahren auszuführen.

Ein weiterer Aspekt der vorliegenden Erfindung betrifft eine Verwendung einer Gerüstdatenbank in einem genannten computerimplementierten Verfahren, wobei in der Gerüstdatenbank zumindest Gerüstfeldcodierungen für vordefinierte Gerüstfelder, Bauteilcodierungen für vordefinierte Gerüstbauteile, sowie Informationen über die Geometrie der Gerüstfelder und Gerüstbauteile enthalten sind; und/oder die Verwendung eines trainierten Algorithmuses, der eingerichtet ist, zumindest ein optisches Kennzeichnungsmerkmal der Gerüstbauteile und/oder der Gerüstfelder zu identifizieren und den Gerüstbauteilen und/oder den Gerüstfeldern eine Codierung zuzuordnen, die in der zumindest einen Gerüstdatenbank in Verbindung mit dem optischen Kennzeichnungsmerkmal hinterlegt ist.

Ein weiterer Aspekt der vorliegenden Erfindung betrifft ein Verfahren zur Codierung von Gerüstdaten, umfassend:
Bereitstellen zumindest einer Gerüstdatenbank, in der zumindest Gerüstfeldcodierungen für vordefinierte Gerüstfelder, Bauteilcodierungen für vordefinierte Gerüstbauteile, sowie Informationen über die Geometrie der Gerüstfelder und Gerüstbauteile enthalten sind;
Bereitstellen von Gerüstdaten eines Gerüstes, umfassend Informationen zu den im Gerüst vorgesehenen Gerüstfelder und den in den jeweiligen Gerüstfeldern vorgesehenen Gerüstbauteile;
Zuordnen von Gerüstfeldcodierungen aus der Gerüstdatenbank zu den Gerüstfeldern des Gerüstes;
Zuordnen von Bauteilcodierungen aus der Gerüstdatenbank zu den in den jeweiligen Gerüstfeldern vorgesehenen Gerüstbauteile, wobei die Bauteilcodierungen eines jeweiligen Gerüstfeldes mit der Gerüstfeldcodierung des jeweiligen Gerüstfeldes verknüpft ist;
Bereitstellen von codierten Gerüstdaten, umfassend zumindest die zugeordneten Gerüstfeldcodierungen und Bauteilcodierungen des Gerüstes.

Ein weiterer Aspekt der vorliegenden Erfindung betrifft eine Codiervorrichtung, eingerichtet zur Codierung von Gerüstdaten, umfassend:
eine Bereitstelleinheit, eingerichtet zum Bereitstellen zumindest einer Gerüstdatenbank, in der zumindest Gerüstfeldcodierungen für vordefinierte Gerüstfelder, Bauteilcodierungen für vordefinierte Gerüstbauteile, sowie Informationen über die Geometrie der Gerüstfelder und Gerüstbauteile enthalten sind;
eine weitere Bereitstelleinheit, eingerichtet zum Bereitstellen von Gerüstdaten eines Gerüstes, umfassend Informationen zu den im Gerüst vorgesehenen Gerüstfelder und den in den jeweiligen Gerüstfeldern vorgesehenen Gerüstbauteile;
eine Zuordnungseinheit, eingerichtet zum Zuordnen von Gerüstfeldcodierungen aus der Gerüstdatenbank zu den Gerüstfeldern des Gerüstes;
eine weitere Zuordnungseinheit, eingerichtet zum Zuordnen von Bauteilcodierungen aus der Gerüstdatenbank zu den in den jeweiligen Gerüstfeldern vorgesehenen Gerüstbauteile, wobei die Bauteilcodierungen eines jeweiligen Gerüstfeldes mit der Gerüstfeldcodierung des jeweiligen Gerüstfeldes verknüpft ist;
eine weitere Bereitstelleinheit, eingerichtet zum Bereitstellen von codierten Gerüstdaten, umfassend zumindest die zugeordneten Gerüstfeldcodierungen und Bauteilcodierungen des Gerüstes.

Ein weiterer Aspekt der vorliegenden Erfindung bezieht sich auf ein computerimplementiertes Verfahren zur Decodierung von codierten Gerüstdaten, umfassend:
Bereitstellen zumindest einer Gerüstdatenbank, in der zumindest Gerüstfeldcodierungen für vordefinierte Gerüstfelder, Bauteilcodierungen für vordefinierte Gerüstbauteile, sowie Informationen über die Geometrie der Gerüstfelder und Gerüstbauteile enthalten sind;
Bereitstellen von codierten Gerüstdaten, umfassend zumindest die zugeordneten Gerüstfeldcodierungen und Bauteilcodierungen des Gerüstes.
Bereitstellen decodierter Gerüstdaten durch Decodieren der Gerüstfeld- und Bauteilcodierungen und durch Zugriff auf die zumindest eine Gerüstdatenbank.

Ein weiterer Aspekt der vorliegenden Erfindung bezieht sich auf eine Decodiervorrichtung, eingerichtet zur Decodierung von codierten Gerüstdaten, umfassend:
eine Bereitstelleinheit, eingerichtet zum Bereitstellen zumindest einer Gerüstdatenbank, in der zumindest Gerüstfeldcodierungen für vordefinierte Gerüstfelder, Bauteilcodierungen für vordefinierte Gerüstbauteile, sowie Informationen über die Geometrie der Gerüstfelder und Gerüstbauteile enthalten sind;
eine weitere Bereitstelleinheit, eingerichtet zum Bereitstellen von codierten Gerüstdaten, umfassend zumindest die zugeordneten Gerüstfeldcodierungen und Bauteilcodierungen des Gerüstes.
eine weitere Bereitstelleinheit, eingerichtet zum Bereitstellen decodierter Gerüstdaten durch Decodieren der Gerüstfeld- und Bauteilcodierungen und durch Zugriff auf die zumindest eine Gerüstdatenbank.

Mit anderen Worten schlägt die vorliegende Erfindung vor, zumindest eine Gerüstdatenbank bereitzustellen, in der die in einem Gerüst vorkommenden Objekte, Gerüstfelder, Gerüstbauteile, Bauteilgruppen, etc. mit einer Codierung hinterlegen sind. Diese Gerüstdatenbank kann anschließend zur Codierung der Gerüstdaten herangezogen werden, indem die jeweiligen Objekte, Gerüstfelder, Gerüstbauteile, Bauteilgruppen, etc. durch eine in der Gerüstdatenbank hinterlegte Codierung ersetzt werden. Dadurch besteht die Möglichkeit, dass ein Gerüst durch eine Zeichenfolge repräsentiert werden kann und nur diese Zeichenfolge an eine mobile Rechnereinheit übermittelt werden kann. Die mobile Rechnereinheit kann anschließend die übermittelte Zeichenfolge Decodieren, indem diese auf die Gerüstdatenbank, die vorzugsweise auch auf der mobilen Rechnereinheit gespeichert ist, zugreifen kann. Anschließend kann eine digitale Darstellung des Gerüsts auf der mobilen Rechnereinheit bereitgestellt werden.

Grundsätzlich müssen dabei im einfachsten Fall keine weiteren Aufbauinstruktionen, Positionsdaten und/oder Lagedaten der Gerüstfelder und/oder der Gerüstbauteile oder dergleichen übermittelt werden, wenn vorab entsprechende Codier- und Decodierregeln zugrunde gelegt werden. Beispielsweis kann als Codier- und Decodierregel zugrundgelegt werden, dass mit der Codierreihenfolge auch eine bestimmte Position eines Gerüstfeldes im Gerüst einhergeht. Beispielsweise kann als Codier- und Decodierregel zugrunde gelegt werden, dass die Codierung mit einem bestimmten Gerüstfeld beginnt, beispielsweise dem Gerüstfeld links-unten, und mit einer bestimmten Reihenfolge weiter verfahren wird. Im einfachsten Fall sind auch keine weiteren Aufbauregeln/-instruktionen hinsichtlich des Auf- und Einbaus der Gerüstbauteile und/oder der Gerüstfelder notwendig, da hierbei auf standardisierte Regelwerke zum Gerüstaufbau zurückgegriffen werden kann, beispielsweise auf die Fachregeln für den Gerüstbau und dergleichen.

Der Begriff "Gerüst" ist vorliegend breit zu verstehen und umfasst jegliche Gerüsttypen, wie beispielsweise Rahmengerüste, Systemgerüste, Sondergerüste, etc.

Der Begriff "Gerüstbauteil" ist vorliegend bereit zu verstehen und umfasst jegliche Elemente/Einheiten etc., die in einem Gerüst eingesetzt werden können. Der Begriff "Gerüstfeld" ist vorliegend breit zu verstehen und umfasst alle im Gerüst vordefinierten Räume. Vorzugsweise ist der Begriff "Gerüstfeld" durch vordefinierte Einheiten eines Gerüstes bestimmt, beispielsweise 2m, 3m, 3,5m Längeneinheiten einer Gerüstlage, mit einer bestimmten Höhe und Breite.

Der Begriff "Gerüstdatenbank" ist vorliegend breit zu verstehen und ist nicht auf einen bestimmten Datenbankaufbau, -struktur oder dergleichen beschränkt. Auch besteht die Möglichkeit, eine dezentrale Datenbank, eine Cloudlösung oder dergleichen je einzusetzen. Die Gerüstdatenbank kann dabei beispielsweise auf der mobilen Rechnereinheit ganz oder teilweise gespeichert sein oder auf einem Baustellenrechner gespeichert sein, der in einem drahtlosen Baustellennetz eingebunden ist, auf den die mobile Rechnereinheit zugreifen kann.

Der Begriff "Gerüstdaten" ist vorliegend breit zu verstehen und kann alle Gerüstspezifischen und/oder Gerüstbauteilspezifischen Daten umfassen. Vorzugsweise werden durch die Gerüstdaten die Informationen zum Aufbau und Struktur des aufzubauenden oder aufgebauten Gerüsts bereitgestellt. Mit anderen Worten, zumindest diejenigen Informationen wo Gerüstfelder und Gerüstbauteile im Gerüst vorgesehen/geplant sind. Die Gerüstdaten können sich dabei auch nur auf einen Teil des aufzubauenden oder aufgebauten Gerüsts beziehen.

Der Begriff "Codierung" ist vorliegend breit zu verstehen und umfasst alle Zeichenketten, Zeichenfolgen, die sich zur Codierung von Gerüstfelder und Gerüstbauteile eigenen. Vorzugsweise kommt dabei eine 4-Stellige Zahlencodierung zum Einsatz. Vorzugsweise erfolgt die Codierung hierarchisch mittels einer hierarchischen Baumstruktur. Die jeweiligen Codierungen, beispielsweise der Gerüstfelder, Gerüstbauteile, Gerüstnummern, Gerüstlagen, sonstiger Einheiten, können dabei entweder in vordefinierter Reihenfolge codiert und übermittelt werden und/oder es können vereinbarte Trennzeichen zwischen jeweiligen Codierungen eingesetzt werden, die sowohl beim Codierer und Decodierer bekannt sind.

Der Begriff "zentrale Rechnereinheit" ist vorliegend breit zu verstehen und umfasst insbesondere Rechnereinheiten, die zur Gerüstplanung eingerichtet sind und die geeignet und eingerichtet sind Gerüstdateien zu erstellen und zu bearbeiten. Der Begriff "mobile Rechnereinheit" ist vorliegend breit zu verstehen und umfasst insbesondere Laptops, Tablets, Smartphones, etc.

Unter Begriff "Übermittlung" ist vorliegend insbesondere eine drahtlose Datenübermittlung auf die mobile Rechnereinheit zu verstehen.

In einer Ausführungsform werden die Gerüstfeldcodierungen und/oder die Bauteilcodierungen als Zeichen- und/oder Zahlenkette bereitgestellt. In einer Ausführungsform sind die Gerüstfeldcodierungen und/oder die Bauteilcodierungen als 4-Stellige Zahlenkette bereitgestellt. Beispielsweise können Gerüstfelder hinsichtlich ihrer Größe/Dimensionen jeweils mit einer Codierung versehen werden.

In einer Ausführungsform werden den Gerüstfeldcodierungen und/oder den Bauteilcodierungen Positionsinformationen und/oder Gerüstlageinformationen zugeordnet, wobei es bevorzugt ist, dass die zumindest eine Gerüstdatenbank vordefinierte Positionsinformationen und/oder vordefinierte Gerüstlageinformationen umfasst und die Positionsinformationen und/oder Gerüstlageinformationen als Positions- und/oder Lagecodierungen zugeordnet werden. Beispielsweise kann einer Gerüstfeldcodierung eine Positions- und/oder Lagecodierungen zugeordnet bzw. mit einer solchen verbunden werden. Eine solche Positions- und/oder Lagecodierungen kann beispielsweise ebenfalls als Zeichenkette dargestellt werden.

In einer Ausführungsform werden unterschiedliche Gerüstdatenbanken bereitgestellt und den Gerüstfeldcodierungen und/oder den Bauteilcodierungen Datenbankinformationen, vorzugsweise als Datenbankcodierung, zugeordnet werden. Dadurch besteht die Möglichkeit auf einfache Weise auf unterschiedliche Gerüstdatenbanken einbinden zu können und auf diese zugreifen zu können.

In einer Ausführungsform werden den Gerüstfeldcodierungen und/oder den Bauteilcodierungen Attribute zugeordnet, wobei den Gerüstfeldcodierungen und/oder den Bauteilcodierungen vorzugsweise Bauteilgewichte, Bauteilidentifikationsnummern, Materialkennwerte und/oder Belastungskennwerte als Attribute zugeordnet werden. Vorzugsweise umfasst die zumindest eine Gerüstdatenbank vordefinierte Attribute und die Attribute werden als Attributcodierung zugeordnet.

In einer Ausführungsform werden Gebäude, Gebäuteile, Wände, Wandteile, Versorgungseinrichtungen oder sonstige Einrichtungen, die am Gerüst oder benachbart zum Gerüst vorgesehen sind, ebenfalls mit einer Codierung versehen bzw. adressiert.

In einer Ausführungsform umfasst die zumindest eine Gerüstdatenbank zumindest einen Datensatz zur digitalen Darstellung der vordefinierten Gerüstfelder und/oder der vordefinierten Gerüstbauteile. Auf einen solchen Datensatz kann dabei zurückgegriffen werden, um eine digitale Darstellung des Gerüstes auf einfache Art und Weise bereitstellen zu können. Ein besonderer Vorteil ist hierbei, dass ein solcher Datensatz einer digitalen Darstellung eines Gerüstbauteils und/oder eines Gerüstfeldes nur einmal in der Datenbank hinterlegt werden muss und hierauf für die Erstellung einer digitalen Darstellung mehrmals zugegriffen werden kann. Ein solcher Datensatz kann dabei eine 2-dimensionale Darstellung und/oder eine 3-dimensionale Darstellung umfassen. Alternativ oder zusätzlich kann eine solche digitale Darstellung auch separat bereitgestellt werden.

In einer Ausführungsform umfasst das computerimplementierte Verfahren weiterhin:
Bereitstellen von Positionsmitteln, die an einer definierten Position relativ zum aufgebauten oder zum aufzubauenden Gerüst angeordnet sind;
Erfassen der Positionsmittel durch zumindest ein Erfassungsmittel;
Bereitstellen einer Gerüstansicht auf einem mobilen visuellen Ausgabemittel, das als Extended Reality (XR), Virtual Reality (VR) und/oder als Augmented Reality (AR)-Einheit ausgebildet ist. Vorzugsweise ist das visuelle Ausgabemittel eine Datenbrille, ein Helm mit Head-up-Display, ein holographisches Element oder eine mobile Rechnereinheit.

In einer Ausführungsform umfasst das computerimplementierte Verfahren weiterhin:
Auswählen eines oder mehrere Gerüstfelder des Gerüstes;
Bereitstellen der Bauteilcodierungen der ausgewählten Gerüstfelder. Dadurch besteht beispielsweise die Möglichkeit Bauteilelisten hinsichtlich der ausgewählten Gerüstfelder bereitstellen zu können, die in der Projektplanung eingesetzt werden können. Beispielsweise können dadurch Lager-, Transportaufgaben zuverlässig geplant und ausgeführt werden.

In einer Ausführungsform umfasst das computerimplementierte Verfahren weiterhin:
Ändern einer übermittelten Gerüstfeldcodierung und/oder einer Bauteilcodierung durch Eingabe einer geänderten Gerüstfeldcodierung und/oder geänderten Bauteilcodierung an Eingabemitteln der mobilen Rechnereinheit;
Übermitteln der geänderten Gerüstfeldcodierung und/oder der geänderten Bauteilcodierung an eine zentrale Rechnereinheit;
Anpassen der Gerüstdaten des Gerüstes an die geänderte Gerüstfeldcodierung und/oder die geänderte Bauteilcodierung. Dadurch bestehet die Möglichkeit während des Aufbaus und/oder bei Baustellenbegehung Änderungen vorzunehmen, die von der mobilen Rechnereinheit an eine zentrale Rechnereinheit übermittelt werden. Mit anderen Worten, kann vorgesehen sein, dass auch die mobile Rechnereinheit einen codierte Gerüstdaten erstellt und an eine zentrale Rechnereinheit übermittelt.

In einer Ausführungsform umfasst das computerimplementierte Verfahren weiterhin:
Bereitstellen von vordefinierten Anpassungsregeln für benachbarte Gerüstfeldcodierungen und/oder Bauteilcodierungen bei Änderung einer Gerüstfeldcodierung und/oder einer Bauteilcodierung;
Anpassen der benachbarten Gerüstfelder und/oder Bauteilcodierungen gemäß den Anpassungsregeln bei Änderung eines Gerüstfeldes. Dadurch besteht die Möglichkeit, automatisierte Anpassungsregeln vorzusehen, wenn Gerüstfelder und/oder Gerüstbauteile eines Gerüstfeldes geändert werden. Wenn beispielsweise die Länge eines Gerüstfeldes geändert wird, durch ändern des Gerüstfeldcodes, kann vorgesehen sein, dass die darüber liegenden Gerüstfelder automatisch an die Länge geänderte Länge des darunter liegenden Gerüstfeldes angepasst werden, indem auch für die darüber liegenden Gerüstfelder der Gerüstfeldcode entsprechend geändert wird. Entsprechend kann auch vorgesehen sein, dass sich die Bauteilcodes eines Gerüstfeldes automatisch an einen geänderten Gerüstfeldcode anpassen. Beispielsweise können die jeweiligen Bauteilcodes eines Gerüstfeldes automatsch angepasst werden, wenn die Dimensionierung des Gerüstfeldes geändert wird.

In einer Ausführungsform umfasst das computerimplementierte Verfahren weiterhin:
Bereitstellen eines Bildes von Gerüstfeldern und/oder Gerüstbauteilen des Gerüstes, die bereits aufgebaut wurden;
Bereitstellen eines trainierten Algorithmuses, der eingerichtet ist, zumindest ein optisches Kennzeichnungsmerkmal der Gerüstbauteile und/oder der Gerüstfelder zu identifizieren und den Gerüstbauteilen und/oder Gerüstfeldern eine Codierung zuzuordnen, die in der zumindest einen Gerüstdatenbank in Verbindung mit dem optischen Kennzeichnungsmerkmal hinterlegt ist;
Zuordnen von Gerüstfeldcodierungen und/oder Bauteilcodierungen basierend auf den bereitgestellten Bildern und dem trainierten Algorithmus;
Übermitteln der zugeordneten Gerüstfeldcodierungen und/oder der zugeordneten Bauteilcodierungen an eine zentrale Rechnereinheit. Dadurch besteht die Möglichkeit, auf einfache Art und Weise codierte Gerüstdaten eines Gerüstes bereitstellen zu können. Als optische Kennzeichnungsmerkmale können beispielsweise entsprechende Farbkodierungen/Farbkennzeichen herangezogen werden.

In einer Ausführungsform umfasst das computerimplementierte Verfahren weiterhin:
Bereitstellen eines Aufmaß-Datensatzes, umfassend eine Aufmaßfläche, wobei der Aufmaß-Datensatz vorzugsweise als Distributed-Ledger-Datensatz, insbesondere als Blockchain-Datensatz, bereitgestellt wird. Als Aufmaß ist dabei diejenige Fläche eines Gebäudes zu verstehen, das vom Gerüst eingedeckt ist. Mit anderen Worten, die Schnittfläche von Gerüstfläche und Gebäudefläche.

In einer Ausführungsform umfasst das computerimplementierte Verfahren weiterhin:
Eingabe von Gerüstfeldcodierungen und/oder Bauteilcodierungen des Gerüstes, die bereits aufgebaut wurden;
Übermitteln der Gerüstfeldcodierungen und/oder Bauteilcodierungen des Gerüstes, die bereits aufgebaut wurden, an eine zentrale Recheneinheit;
Zuordnen einer Fertigstellungscodierung an die Gerüstfeldcodierungen und/oder Bauteilcodierungen, die bereits aufgebaut wurden. Diese Informationen können beispielsweise für die weitere Projektplanung und Projektabwicklung herangezogen werden.

In einer Ausführungsform umfasst das computerimplementierte Verfahren weiterhin:
Bereitstellen der Gerüstfeldcodierungen und/oder der Bauteilcodierungen der Gerüstfelder, die keine Fertigstellungscodierung aufweisen bzw. denen noch keine Fertigstellungscodierung zugeordnet ist. Auch diese Informationen können für die weitere Projektplanung und Projektabwicklung herangezogen werden.

In einer Ausführungsform umfasst das computerimplementierte Verfahren weiterhin:
Ermitteln einer Arbeits-Kennzahl für das Gerüst basierend auf den jeweiligen Lagen- bzw. Einbauhöhen der Gerüstbauteile und des Gewichts der Gerüstbauteile; oder
Ermitteln einer Arbeits-Kennzahl für eine Auswahl von Gerüstfeldern basierend auf den jeweiligen Lagen- bzw. Einbauhöhen der Gerüstbauteile und des Gewichts der Gerüstbauteile; oder
Ermitteln einer Arbeits-Kennzahl für ein Gerüstfeld basierend auf den jeweiligen Lagen- bzw. Einbauhöhen der Gerüstbauteile des Gerüstfelds und des Gewichts der Gerüstbauteile des Gerüstfeldes. Durch derartige Arbeits-Kennzahlen, beispielsweise angegeben in N/m, Joule, Kilokalorie, etc., besteht die Möglichkeit einem Gerüst eine objektive Aufwandskennzahl zuordnen zu können, die einen objektiven Aufwandsvergleich unterschiedlicher Gerüste ermöglicht.

Die im Zusammenhang mit dem oben genannten Verfahren erläuterten Ausführungsformen, Vorteile und Effekte, gelten ebenfalls korrespondierend für die hier genannten Systeme, Vorrichtungen, Computerprogrammelemente und/oder für die genannten Anwendungen.

### Beschreibung einer bevorzugten Ausführungsform

Weitere Merkmale, Vorteile und Anwendungsmöglichkeiten der vorliegenden Erfindung ergeben sich aus der nachfolgenden Beschreibung, dem Ausführungsbeispiel und den Figuren. Darin zeigen:
- **Figur 1**: eine schematische Darstellung der Schritte eines erfindungsgemäßen Verfahrens;
- **Figur 2**: eine schematische Ansicht eines erfindungsgemäßen Systems;
- **Figur 3**: eine schematische Darstellung eines vierseitigen Gerüstes;
- **Figur 4**: eine schematische Ansicht einer Gerüstseite mit unterschiedlichen Gerüstfeldern; und
- **Figur 5**: eine schematische Ansicht der Gerüstseite aus Figur 4.

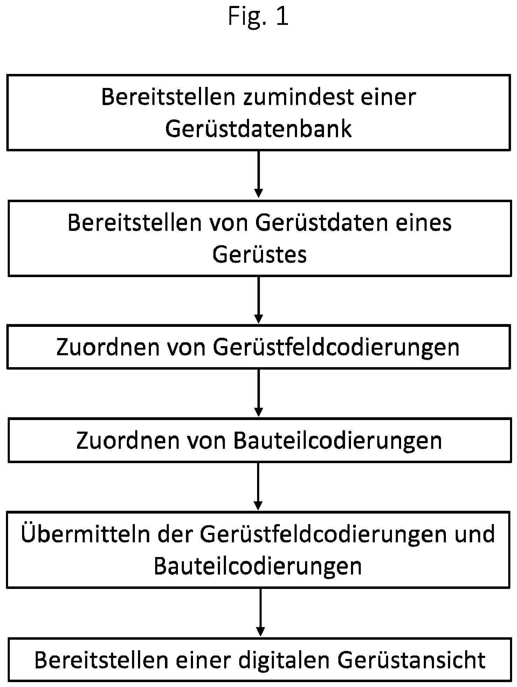

**Figur 1** zeigt eine schematische Darstellung der Schritte eines erfindungsgemäßen Verfahrens zur Codierung, Übertragung und Decodierung von Gerüstdaten. In einem ersten Schritt wird dabei zumindest eine Gerüstdatenbank bereitgestellt, in der zumindest Gerüstfeldcodierungen für vordefinierte Gerüstfelder, Bauteilcodierungen für vordefinierte Gerüstbauteile, sowie Informationen über die Geometrie der Gerüstfelder und Gerüstbauteile enthalten sind. In einem weiteren Schritt werden Gerüstdaten eines Gerüstes bereitgestellt, umfassend Informationen zu den im Gerüst vorgesehenen Gerüstfelder und den in den jeweiligen Gerüstfeldern vorgesehenen Gerüstbauteile. In einem weiteren Schritt werden den Gerüstfeldern Gerüstfeldcodierungen aus der Gerüstdatenbank zugeordnet. In einem weiteren Schritt werden den Gerüstbauteilen Bauteilcodierungen aus der Gerüstdatenbank zugeordnet, wobei die Bauteilcodierungen eines jeweiligen Gerüstfeldes mit der Gerüstfeldcodierung des jeweiligen Gerüstfeldes verknüpft ist/wird. In einem weiteren Schritt werden die jeweiligen Gerüstfeldcodierungen und der damit verknüpften Bauteilcodierungen an eine mobile Rechnereinheit übermittelt, wobei die mobile Rechnereinheit Zugriff auf die zumindest eine Gerüstdatenbank hat. In einem weiteren Schritt wird eine digitale Gerüstansicht durch Decodieren der übermittelten Gerüstfeld- und Bauteilcodierungen und durch Zugriff auf die zumindest eine Gerüstdatenbank bereitgestellt.

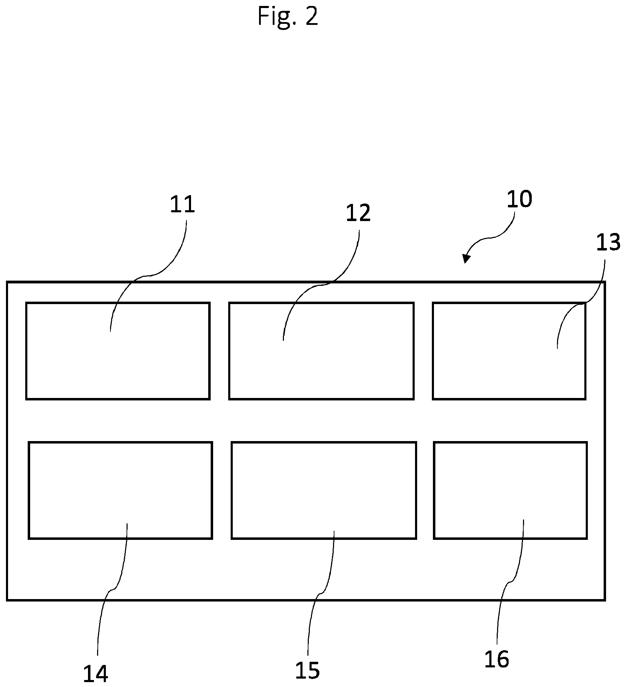

**Figur 2** zeigt ein System 10 zur Codierung, Übertragung und Decodierung von Gerüstdaten, umfassend: eine Bereitstelleinheit 11 eingerichtet zum Bereitstellen zumindest einer Gerüstdatenbank, in der zumindest Codierungen für vordefinierte Gerüstfelder, Codierungen für vordefinierte Gerüstbauteile, sowie Informationen über die Geometrie der Gerüstfelder und Gerüstbauteile enthalten sind; eine weitere Bereitstelleinheit 12 eingerichtet zum Bereitstellen von Gerüstdaten eines Gerüstes, umfassend Informationen zu den im Gerüst vorgesehenen Gerüstfelder und den in den jeweiligen Gerüstfeldern vorgesehenen Gerüstbauteile; eine Zuordnungseinheit 13 eingerichtet zum Zuordnen von Codierungen aus der Gerüstdatenbank zu den Gerüstfeldern des Gerüstes; eine weitere Zuordnungseinheit 14 eingerichtet zum Zuordnen von Codierungen aus der Gerüstdatenbank zu den in den jeweiligen Gerüstfeldern vorgesehenen Gerüstbauteile, wobei die Codierungen der Gerüstbauteile eines jeweiligen Gerüstfeldes mit der Codierung des jeweiligen Gerüstfeldes verknüpft ist; eine Übermittlungseinheit 15 eingerichtet zum Übermitteln der Codierungen der jeweiligen Gerüstfelder und der damit verknüpften Codierungen der darin jeweils vorgesehenen Gerüstbauteile an eine mobile Rechnereinheit, wobei die mobile Rechnereinheit Zugriff auf die zumindest eine Gerüstdatenbank hat; eine weitere Bereitstelleinheit 16 eingerichtet zum Bereitstellen einer digitalen Gerüstansicht durch Decodieren der übermittelten Codierungen und Zugriff auf die zumindest eine Gerüstdatenbank.

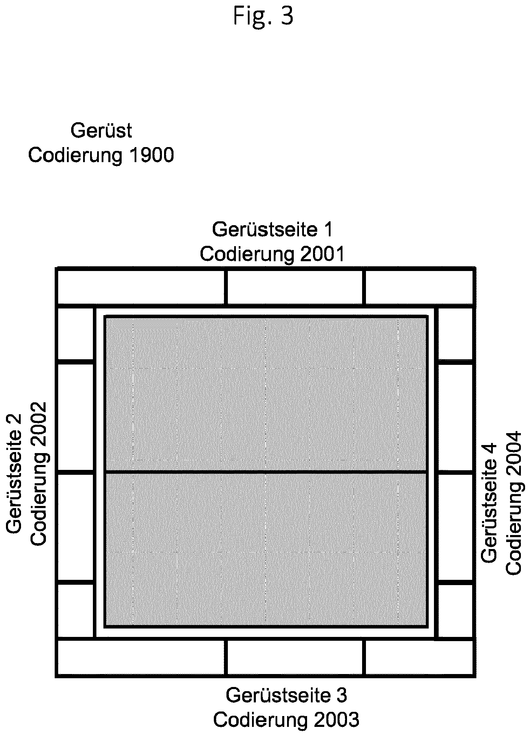

**Figur 3** zeigt eine schematische Draufsicht auf ein vierseitiges Gerüst. Dem dort gezeigten Gerüst wurde dabei eine Codierung "1900" zugeordnet. In der Gerüstdatenbank können zu dieser Codierung "1900" weitere Information hinterlegt werden. Beispielsweise, welcher Gerüstklasse das Gerüst hat wo das gezeigte Gerüst aufgebaut werden soll oder aufgebaut wurde. Auch können hierzu Standortbesonderheiten und dergleichen in der Gerüstdatenbank hinterlegt werden. Denn verschiedenen Gerüstseiten sind dabei ebenfalls jeweils Codierungen zugeordnet, hier beispielsweise die Codierungen "2001", "2002", "2003" und "2004". Die in **Figur 3** gezeigte obere Gerüstseite dieses vierseitigen Gerüstes kann daher durch eine Kombination der beiden Codierungen "1900" und "2001" eindeutig bestimmt werden.

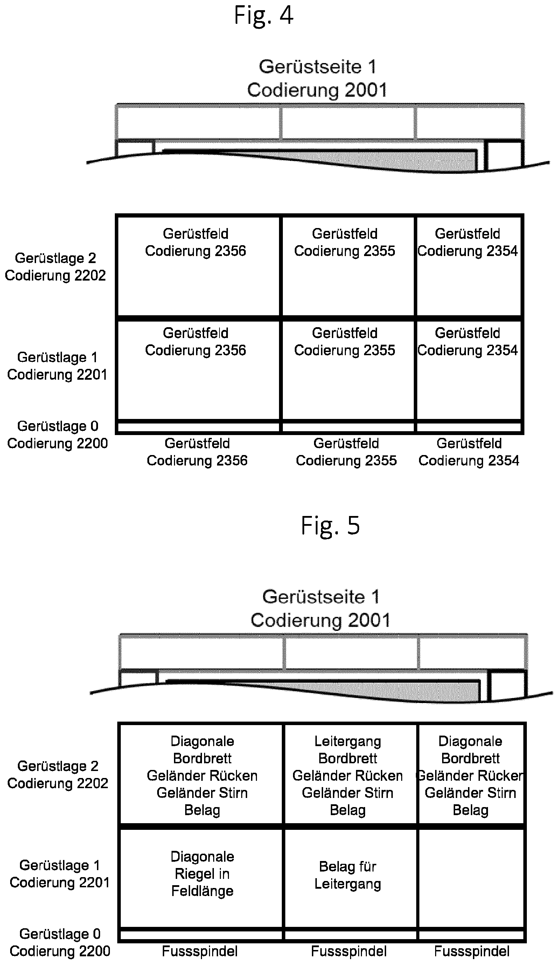

**Figur 4** zeigt eine Ansicht der Gerüstseite "2001" aus **Figur 3**. Wie in **Figur 4** gezeigt, sind den Gerüstlagen die Codierungen "2200" für die Gerüstlage 0, die Codierung "2201" für die Gerüstlage 1 und die Codierung "2202" für die Gerüstlage 2 zugeordnet. Solche Codierungen für die Gerüstlagen werden allerdings nicht zwingend benötigt, beispielsweise bei nur einlagigen Gerüsten oder bei Gerüsten mit vordefinierten Gerüstfeldern pro Gerüstlage.

Die Gerüstfelder in der Gerüstlage 0 sind dabei mit "2356", "2355" und "2354" codiert. Eine weitere Codierung der Position eines Gerüstfeldes in einer Gerüstlage ist dabei nicht zwingen notwendig, wenn eine entsprechende Reihenfolgeregelung getroffen wurde. Beispielsweise, dass in jeder Gerüstlage die Anordnung der Gerüstfelder auf der linken Seite beginnt. Die Codierungen der Gerüstfelder beziehen sich dabei auf vordefinierte Dimensionen der Gerüstfelder. Die Codierung "2356" repräsentiert im gezeigten Ausführungsbeispiel ein Gerüstfeld mit einer Länge von 300 mm und einer Tiefe von 67 mm. Die Codierung "2355" repräsentiert im gezeigten Ausführungsbeispiel ein Gerüstfeld mit einer Länge von 250 mm und einer Tiefe von 67 mm. Die Codierung "2354" repräsentiert im gezeigten Ausführungsbeispiel ein Gerüstfeld mit einer Länge von 200 mm und einer Tiefe von 67 mm. Die Zuordnungen der Gerüstfeldcodierungen sind in der zumindest einen Gerüstdatenbank hinterlegt.

**Figur 5** zeigt die Gerüstseite aus **Figur 4****,** wobei in die jeweiligen Gerüstfelder beispielhafte Gerüstbauteile angeführt sind. Welche Gerüstfelder und Gerüstbauteile vorgesehen sind, wird zunächst bei der Gerüstplanung festgelegt.

Denn in **Figur 5** angeführten Gerüstbauteilen können dabei folgende, lediglich beispielhaft angeführten, Bauteilcodierungen zugeordnet werden, die in der zumindest einen Gerüstdatenbank hinterlegt sind.

| | |
|---|---|
| 3134- | STAHLBELAG EDS 33X200 |
| 3135- | STAHLBELAG EDS 33X250 |
| 3136- | STAHLBELAG EDS 33X300 LEITERGANGSTAFEL |
| 3255- | EAW-L 250 |
| | BORDBRETT HOLZ UPF |
| 3534- | 200 BORDBRETT HOLZ UPF |
| 3535- | 250 BORDBRETT HOLZ UPF |
| 3536- | 300 |
| 3922- | EASYBASISSTIEL EVS 124 |
| 3923- | EASY STIEL EVM 200 FUSSSPINDEL UJB 38- |
| 4912- | 50/30 GELAENDERHOLM EPG |
| 4114- | 200 GELAENDERHOLM EPG |
| 4115- | 250 GELAENDERHOLM EPG |
| 4116- | 300 LAENGSDIAGONALE EBF |
| 4216- | 300/200 HORIZONTALRIEGEL UH-2 |
| 4306- | 300 HORIZONTALRIEGEL UH-2 |
| 4350- | 67 HORIZONTALRIEGEL UH-2 |
| 4350- | 67 |
| 4552- | STIRNGELAENDER EPF 67 |

In der Gerüstdatenbank kann darüber hinaus jeweils ein Datensatz zur digitalen Darstellung der vordefinierten Gerüstfelder und/oder der vordefinierten Gerüstbauteile hinterlegen werden.

Durch die oben bereitgestellten Bauteilcodierungen, den oben angegebenen Gerüstfeldcodierungen und den optionalen weiteren Codierungen kann das gezeigte Gerüst und dessen Aufbau durch nachfolgende verknüpfte Codierungen angegeben werden.

Beispielsweise kann die gezeigte Gerüstlage 0 durch unten gezeigte hierarchische Codierung angegeben werden.

| | **Codierung** | | | | | **Bezeichnung** | |
|---|---|---|---|---|---|---|---|
| | **1900-** | | | | | **Gerüst** | |
| | | **2001-** | | | | **Gerüstseite 1** | |
| | | | **2200-** | | | **Gerüstlage 0** | |
| | | | | 2356- | | Gerüstfeld 67/300 | |
| | | | | | 4912- | | FUSSSPINDEL UJB 38-50/30 |
| | | | | 2355- | | Gerüstfeld 67/250 | |
| | | | | | 4912- | | FUSSSPINDEL UJB 38-50/30 |
| | | | | 2354- | | Gerüstfeld 67/200 | |
| | | | | | 4912- | | FUSSSPINDEL UJB 38-50/30 |

Die gezeigte Gerüstlage 1 kann durch die nachfolgend gezeigte hierarchische Codierung angegeben werden.

| | | | | | |
|---|---|---|---|---|---|
| | | **2201-** | | | **Gerüstlage 1** |
| | | | 2356- | | Gerüstfeld 67/300 |
| | | | | 3922- | EASYBASISSTIEL EVS 124 |
| | | | | 3923- | EASY STIEL EVM 200 |
| | | | | 4216- | LAENGSDIAGONALE EBF 300/200 |
| | | | | 4306- | HORIZONTALRIEGEL UH-2 300 |
| | | | | 4350- | HORIZONTALRIEGEL UH-2 67 |
| | | | 2355- | | Gerüstfeld 67/250 |
| | | | | 3135- | STAHLBELAG EDS 33X250 |
| | | | | 3922- | EASYBASISSTIEL EVS 124 |
| | | | | 3923- | EASY STIEL EVM 200 |
| | | | | 4350- | HORIZONTALRIEGEL UH-2 67 |
| | | | 2354- | | Gerüstfeld 67/200 |
| | | | | 3922- | EASYBASISSTIEL EVS 124 |
| | | | | 3923- | EASY STIEL EVM 200 |
| | | | | 4350- | HORIZONTALRIEGEL UH-2 67 |

Die gezeigte Gerüstlage 2 kann durch die nachfolgend gezeigte hierarchische Codierung angegeben werden.

| | | | | | |
|---|---|---|---|---|---|
| | | **2202-** | | | **Gerüstlage 2** |
| | | | 2356- | | Gerüstfeld 67/300 |
| | | | | 3136- | STAHLBELAG EDS 33X300 |
| | | | | 3536- | BORDBRETT HOLZ UPF 300 |
| | | | | 3923- | EASY STIEL EVM 200 |
| | | | | 4116- | GELAENDERHOLM EPG 300 |
| | | | | 4216- | LAENGSDIAGONALE EBF 300/200 |
| | | | | 4350- | HORIZONTALRIEGEL UH-2 67 |
| | | | | 4552- | STIRNGELAENDER EPF 67 |
| | | | 2355- | | Gerüstfeld 67/250 |
| | | | | 3255- | LEITERGANGSTAFEL EAW-L 250 |
| | | | | 3535- | BORDBRETT HOLZ UPF 250 |
| | | | | 3923- | EASY STIEL EVM 200 |
| | | | | 4115- | GELAENDERHOLM EPG 250 |
| | | | | 4350- | HORIZONTALRIEGEL UH-2 67 |
| | | | 2354- | | Gerüstfeld 67/200 |
| | | | | 3134- | STAHLBELAG EDS 33X200 |
| | | | | 3534- | BORDBRETT HOLZ UPF 200 |
| | | | | 3923- | EASY STIEL EVM 200 |
| | | | | 4114- | GELAENDERHOLM EPG 200 |
| | | | | 4350- | HORIZONTALRIEGEL UH-2 67 |
| | | | | 4552- | STIRNGELAENDER EPF 67 |

Die oben gezeigten Codierungen für das beispielhaft gezeigte Gerüst können anschließend als Datei an eine mobile Rechnereinheit übermittelt werden. Unter Rückgriff auf die Gerüstdatenbank kann die mobile Rechnereinheit wiederum eine Decodierung vornehmen und eine digitale Darstellung des Gerüstes bereitstellen.

Die hier dargestellten Codierungen und Verknüpfungen der unterschiedlichen Codierungsebenen sind lediglich beispielhaft. Andere Codierungen, Codierungsstrukturen, etc. und sind ebenfalls möglich.

Die vorliegende Erfindung ist dabei allerdings nicht auf die vorhergehenden bevorzugten Ausführungsbeispiele beschränkt, solange sie vom Gegenstand der folgenden Ansprüche umfasst ist.

Ergänzend wird darauf hingewiesen, dass die Begriffe "umfassend" und "aufweisend" keine anderen Elemente oder Schritte ausschließen und die unbestimmten Artikel "eine" oder "ein" keine Vielzahl ausschließen. Darüber hinaus ist der Begriff der Einheit breit zu verstehen, insbesondere ist dieser Begriff nicht dahingehend zu verstehen, dass die jeweiligen Einheiten als integrale Bauteile ausgebildet sein müssen. Auch können die jeweiligen Einheiten auch unterschiedlich positioniert und an unterschiedlichen Orten vorgesehen werden. Ferner wird darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können.

## Patentansprüche

1. Computerimplementiertes Verfahren zur Codierung, Übertragung und Decodierung von Gerüstdaten, umfassend:
Bereitstellen zumindest einer Gerüstdatenbank, in der zumindest Gerüstfeldcodierungen für vordefinierte Gerüstfelder, Bauteilcodierungen für vordefinierte Gerüstbauteile, sowie Informationen über die Geometrie der Gerüstfelder und Gerüstbauteile enthalten sind;
Bereitstellen von Gerüstdaten eines Gerüstes, umfassend Informationen zu den im Gerüst vorgesehenen Gerüstfelder und den in den jeweiligen Gerüstfeldern vorgesehenen Gerüstbauteile;
Zuordnen von Gerüstfeldcodierungen aus der Gerüstdatenbank zu den Gerüstfeldern des Gerüstes;
Zuordnen von Bauteilcodierungen aus der Gerüstdatenbank zu den in den jeweiligen Gerüstfeldern vorgesehenen Gerüstbauteile, wobei die Bauteilcodierungen eines jeweiligen Gerüstfeldes mit der Gerüstfeldcodierung des jeweiligen Gerüstfeldes verknüpft ist;
Übermitteln der jeweiligen Gerüstfeldcodierungen und der damit verknüpften Bauteilcodierungen an eine mobile Rechnereinheit, wobei die mobile Rechnereinheit Zugriff auf die zumindest eine Gerüstdatenbank hat;
Bereitstellen einer digitalen Gerüstansicht durch Decodieren der übermittelten Gerüstfeld- und Bauteilcodierungen und durch Zugriff auf die zumindest eine Gerüstdatenbank.

2. Computerimplementiertes Verfahren nach Anspruch 1, wobei die Gerüstfeldcodierungen und/oder die Bauteilcodierungen als Zeichen- und/oder Zahlenkette bereitgestellt werden, wobei die Gerüstfeldcodierungen und/oder die Bauteilcodierungen vorzugsweise als 4-Stellige Zahlenkette bereitgestellt werden.

3. Computerimplementiertes Verfahren nach einem der vorhergehenden Ansprüche, wobei den Gerüstfeldcodierungen und/oder den Bauteilcodierungen Positionsinformationen und/oder Gerüstlageinformationen zugeordnet werden, wobei die zumindest eine Gerüstdatenbank vorzugsweise vordefinierte Positionsinformationen und/oder vordefinierte Gerüstlageinformationen umfasst und die Positionsinformationen und/oder Gerüstlageinformationen als Positions- und/oder Lagecodierungen zugeordnet werden.

4. Computerimplementiertes Verfahren nach einem der vorhergehenden Ansprüche, wobei den Gerüstfeldcodierungen und/oder den Bauteilcodierungen Attribute zugeordnet werden, wobei den Gerüstfeldcodierungen und/oder den Bauteilcodierungen vorzugsweise Bauteilgewichte, Bauteilidentifikationsnummern, Materialkennwerte und/oder Belastungskennwerte als Attribute zugeordnet werden, und wobei die zumindest eine Gerüstdatenbank vorzugsweise vordefinierte Attribute umfasst und die Attribute als Attributcodierung zugeordnet werden.

5. Computerimplementiertes Verfahren nach einem der vorhergehenden Ansprüche, wobei die zumindest eine Gerüstdatenbank zumindest einen Datensatz zur digitalen Darstellung der vordefinierten Gerüstfelder und/oder der vordefinierten Gerüstbauteile umfasst.

6. Computerimplementiertes Verfahren nach einem der vorhergehenden Ansprüche, weiterhin umfassend:
Bereitstellen von Positionsmitteln, die an einer definierten Position relativ zum aufgebauten oder zum aufzubauenden Gerüst angeordnet sind,
Erfassen der Positionsmittel durch zumindest ein Erfassungsmittel;
Bereitstellen einer Gerüstansicht auf einem mobilen visuellen Ausgabemittel, das als Extended Reality (XR), Virtual Reality (VR) und/oder als Augmented Reality (AR)-Einheit ausgebildet ist, wobei das visuelle Ausgabemittel vorzugsweise eine Datenbrille, ein Helm mit Head-up-Display, ein holographisches Element oder eine mobile Rechnereinheit ist.

7. Computerimplementiertes Verfahren nach einem der vorhergehenden Ansprüche, weiterhin umfassend:
Auswählen eines oder mehrere Gerüstfelder des Gerüstes;
Bereitstellen der Bauteilcodierungen der ausgewählten Gerüstfelder.

8. Computerimplementiertes Verfahren nach einem der vorhergehenden Ansprüche, weiterhin umfassend:
Ändern einer übermittelten Gerüstfeldcodierung und/oder einer Bauteilcodierung durch Eingabe einer geänderten Gerüstfeldcodierung und/oder geänderten Bauteilcodierung an Eingabemitteln der mobilen Rechnereinheit;
Übermitteln der geänderten Gerüstfeldcodierung und/oder der geänderten Bauteilcodierung an eine zentrale Rechnereinheit;
Anpassen der Gerüstdaten des Gerüstes an die geänderte Gerüstfeldcodierung und/oder die geänderte Bauteilcodierung, wobei das Verfahren weiterhin vorzugsweise umfasst:
Bereitstellen von vordefinierten Anpassungsregeln für benachbarte Gerüstfeldcodierungen und/oder Bauteilcodierungen bei Änderung einer Gerüstfeldcodierung und/oder einer Bauteilcodierung;
Anpassen der benachbarten Gerüstfelder und/oder Bauteilcodierungen gemäß den Anpassungsregeln bei Änderung eines Gerüstfeldes.

9. Computerimplementiertes Verfahren nach einem der vorhergehenden Ansprüche, weiterhin umfassend:
Bereitstellen eines Bildes von Gerüstfeldern und/oder Gerüstbauteilen des Gerüstes, die bereits aufgebaut wurden;
Bereitstellen eines trainierten Algorithmus, der eingerichtet ist, zumindest ein optisches Kennzeichnungsmerkmal der Gerüstbauteile und/oder der Gerüstfelder zu identifizieren und den Gerüstbauteilen und/oder Gerüstfeldern eine Codierung zuzuordnen, die in der zumindest einen Gerüstdatenbank in Verbindung mit dem optischen Kennzeichnungsmerkmal hinterlegt ist;
Zuordnen von Gerüstfeldcodierungen und/oder Bauteilcodierungen basierend auf den bereitgestellten Bildern und dem trainierten Algorithmus;
Übermitteln der zugeordneten Gerüstfeldcodierungen und/oder der zugeordneten Bauteilcodierungen an eine zentrale Rechnereinheit.

10. Computerimplementiertes Verfahren nach einem der vorhergehenden Ansprüche, weiterhin umfassend:
Bereitstellen eines Aufmaß-Datensatzes, umfassend eine Aufmaßfläche, wobei der Aufmaß-Datensatz vorzugsweise als Distributed-Ledger-Datensatz, insbesondere als Blockchain-Datensatz, bereitgestellt wird.

11. Computerimplementiertes Verfahren nach einem der vorhergehenden Ansprüche, weiterhin umfassend:
Eingabe von Gerüstfeldcodierungen und/oder Bauteilcodierungen des Gerüstes, die bereits aufgebaut wurden;
Übermitteln der Gerüstfeldcodierungen und/oder Bauteilcodierungen des Gerüstes, die bereits aufgebaut wurden, an eine zentrale Recheneinheit;
Zuordnen einer Fertigstellungscodierung an die Gerüstfeldcodierungen und/oder Bauteilcodierungen, die bereits aufgebaut wurden, wobei das Verfahren weiterhin vorzugsweise umfasst:
Bereitstellen der Gerüstfeldcodierungen und/oder Bauteilcodierungen der Gerüstfelder, die keine Fertigstellungscodierung aufweisen.

12. Computerimplementiertes Verfahren nach einem der vorhergehenden Ansprüche, weiterhin umfassend:
Ermitteln einer Arbeits-Kennzahl für das Gerüst basierend auf den jeweiligen Lagen- bzw. Einbauhöhen der Gerüstbauteile und des Gewichts der Gerüstbauteile; oder
Ermitteln einer Arbeits-Kennzahl für eine Auswahl von Gerüstfeldern basierend auf den jeweiligen Lagen- bzw. Einbauhöhen der Gerüstbauteile und des Gewichts der Gerüstbauteile; oder
Ermitteln einer Arbeits-Kennzahl für ein Gerüstfeld basierend auf den jeweiligen Lagen- bzw. Einbauhöhen der Gerüstbauteile des Gerüstfelds und des Gewichts der Gerüstbauteile des Gerüstfeldes.

13. System zur Codierung, Übertragung und Decodierung von Gerüstdaten, umfassend:
eine Bereitstelleinheit eingerichtet zum Bereitstellen zumindest einer Gerüstdatenbank, in der zumindest Codierungen für vordefinierte Gerüstfelder, Codierungen für vordefinierte Gerüstbauteile, sowie Informationen über die Geometrie der Gerüstfelder und Gerüstbauteile enthalten sind;
eine weitere Bereitstelleinheit eingerichtet zum Bereitstellen von Gerüstdaten eines Gerüstes, umfassend Informationen zu den im Gerüst vorgesehenen Gerüstfelder und den in den jeweiligen Gerüstfeldern vorgesehenen Gerüstbauteile;
eine Zuordnungseinheit eingerichtet zum Zuordnen von Codierungen aus der Gerüstdatenbank zu den Gerüstfeldern des Gerüstes;
eine weitere Zuordnungseinheit eingerichtet zum Zuordnen von Codierungen aus der Gerüstdatenbank zu den in den jeweiligen Gerüstfeldern vorgesehenen Gerüstbauteile, wobei die Codierungen der Gerüstbauteile eines jeweiligen Gerüstfeldes mit der Codierung des jeweiligen Gerüstfeldes verknüpft ist;
eine Übermittlungseinheit eingerichtet zum Übermitteln der Codierungen der jeweiligen Gerüstfelder und der damit verknüpften Codierungen der darin jeweils vorgesehenen Gerüstbauteile an eine mobile Rechnereinheit, wobei die mobile Rechnereinheit Zugriff auf die zumindest eine Gerüstdatenbank hat;
eine weitere Bereitstelleinheit eingerichtet zum Bereitstellen einer digitalen Gerüstansicht durch Decodieren der übermittelten Codierungen und Zugriff auf die zumindest eine Gerüstdatenbank.

14. Computerprogrammelement mit Anweisungen, die bei Ausführung auf Computergeräten einer Computerumgebung eingerichtet sind, um die Schritte des Verfahrens nach einem der Ansprüche 1 bis 12 in einem System nach Anspruch 13 auszuführen.

15. Verwendung einer Gerüstdatenbank in einem Verfahren nach einem der Ansprüche 1 bis 12, wobei in der Gerüstdatenbank zumindest Gerüstfeldcodierungen für vordefinierte Gerüstfelder, Bauteilcodierungen für vordefinierte Gerüstbauteile, sowie Informationen über die Geometrie der Gerüstfelder und Gerüstbauteile enthalten sind; und/oder Verwendung eines trainierten Algorithmus, der eingerichtet ist, zumindest ein optisches Kennzeichnungsmerkmal der Gerüstbauteile und/oder der Gerüstfelder zu identifizieren und den Gerüstbauteilen und/oder Gerüstfeldern eine Codierung zuzuordnen, die in der zumindest einen Gerüstdatenbank in Verbindung mit dem optischen Kennzeichnungsmerkmal hinterlegt ist.
